# EUROPÄISCHE PATENTANMELDUNG

(11) **EP 1 170 750 A1**
(43) Veröffentlichungstag der Anmeldung: **09.01.2002**
(21) Anmeldenummer: 01113928.4
(22) Anmeldetag: 07.06.2001
(51) Int. Cl.: G11C 8/00, G11C 7/12

(54) **Strom-Treiberanordnung für MRAM**

(30) Priorität: 03.07.2000 DE 10032272
(71) Anmelder: Infineon Technologies AG, 81669 München (DE)
(72) Erfinder: Boehm, Thomas, 85604 Zorneding (DE); Gogl, Dietmar, 12524 Fishkill, NY (US); Mueller, Gerhard, Dr., 86405 Meitingen (DE); Roehr, Thomas, Dr., 85609 Aschheim (DE)
(74) Vertreter: Müller . Hoffmann & Partner Patentanwälte

(57) **Zusammenfassung**

Die Erfindung betrifft eine Strom-Treiberanordnung für MRAMs, bei der Wortleitungs- und Bitleitungs-Treiber (T2, T1) aus der Reihenschaltung eines n-Kanal-Feldeffekttransistors (N0, N6) mit einer Stromquelle (J0, J3) bestehen.

## Beschreibung

Die vorliegende Erfindung betrifft eine Strom-Treiberanordnung für einen MRAM (magnetoresistiver Speicher) aus einem Speicherzellenfeld mit einer Vielzahl von Speicherzellen an Kreuzungsstellen von Wortleitungen mit Bitleitungen und aus den Wortleitungen und den Bitleitungen zugeordneten Treibern, die jeweils an einem Ende der Wortleitungen bzw. Bitleitungen vorgesehen sind.

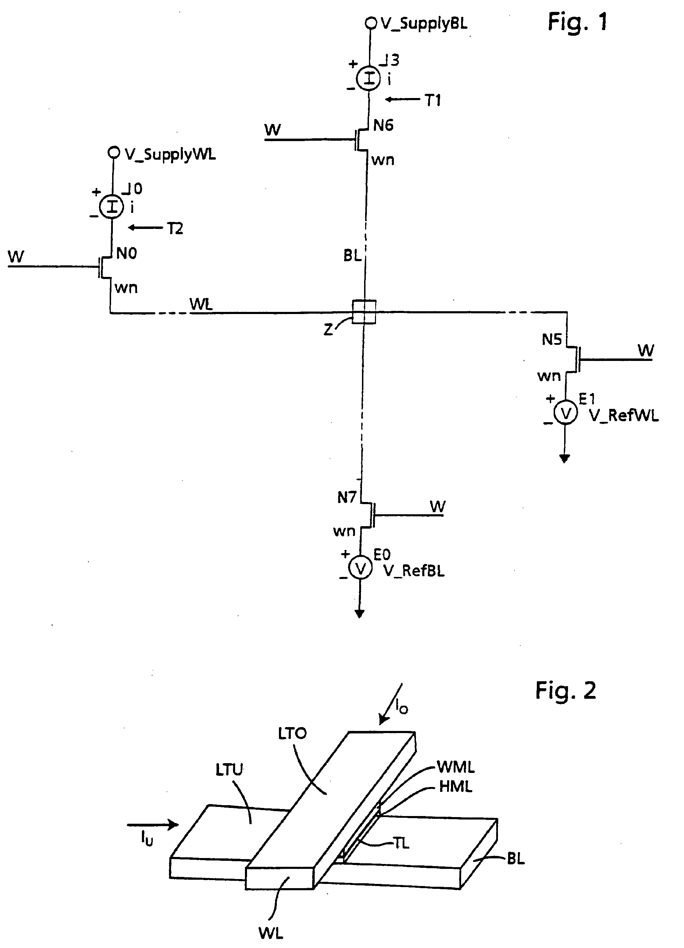

Bei MRAMs wird bekanntlich für den Speichereffekt der magnetisch veränderbare elektrische Widerstand der einzelnen Speicherzellen ausgenutzt. Eine solche Speicherzelle besteht, wie in Fig. 2 gezeigt ist, aus der Kreuzung einer Wortleitung WL, die hier als oberer Leiter LTO angenommen ist, mit einer Bitleitung BL, die durch einen unteren Leiter LTU gebildet ist, wobei an der Kreuzungsstelle zwischen diesen beiden Leitern LTO und LTU ein bestimmtes Mehrschichtsystem zwischen den beiden Leitern LTO und LTU vorliegt. Dieses Mehrschichtsystem besteht aus einer hartmagnetischen Materialschicht HML und einer weichmagnetischen Materialschicht WML, zwischen denen sich ein Tunneloxidfilm TL befindet. Mit anderen Worten, auf den unteren Leiter LTU sind der Reihe nach die hartmagnetische Materialschicht HML, der Tunneloxidfilm TL und die weichmagnetische Materialschicht WML geschichtet, wobei die weichmagnetische Materialschicht WML auf ihrer Oberseite von dem oberen Leiter LTO bedeckt ist.

Die Anordnung der weichmagnetischen Materialschicht WML und der hartmagnetischen Materialschicht HML kann gegebenenfalls auch vertauscht werden, so daß die hartmagnetische Materialschicht HML "oben" angeordnet ist, während sich die weichmagnetische Materialschicht WML auf dem unteren Leiter LTU befindet. Ebenso ist es möglich, für die Bitleitung BL den oberen Leiter LTO und für die Wortleitung WL den unteren Leiter LTU vorzusehen.

Wichtig ist lediglich, daß der Tunneloxidfilm TL zwischen der weichmagnetischen Materialschicht WML und der hartmagnetischen Materialschicht HML liegt, wobei diese beiden Schichten WML bzw. HML jeweils einem oberen Leiter LTO bzw. einem unteren Leiter LTU zugeordnet sind. Anstelle eines Oxids kann für den Tunneloxidfilm auch ein anderes Material verwendet werden.

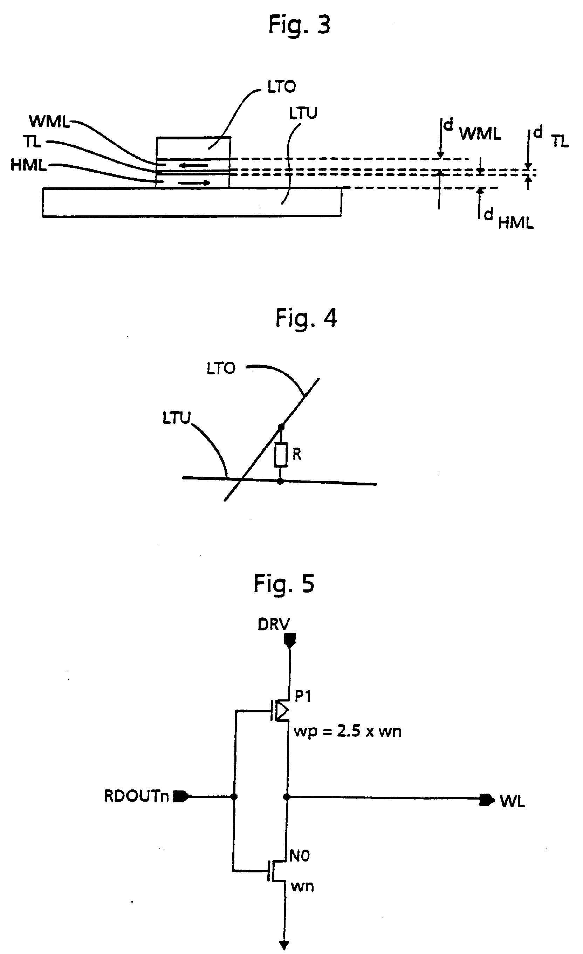

Die Dicke d_{TL} (vgl. Fig. 3) des Tunneloxidfilmes TL kann vorzugsweise im Bereich von 0,5 bis 5 nm liegen. Die Dicke d_{WML} der weichmagnetischen Materialschicht WML und die Dicke d_{HML} der hartmagnetischen Materialschicht HML liegen etwa im Bereich von 1 bis 5 nm. Prinzipiell sind aber auch hiervon abweichende Dicken zulässsig.

Auf diese Weise bildet das Mehrschichtsystem aus der weichmagnetischen Materialschicht WML, dem Tunneloxidfilm TL und der hartmagnetischen Materialschicht HML eine Speicherzelle mit einem Widerstand R zwischen dem oberen Leiter LTO und dem unteren Leiter LTU, so daß die schematisch in Fig. 4 gezeigte Anordnung vorliegt.

Der Widerstandswert des Mehrschichtsystemes, also der Speicherzelle, zwischen den Leitern LTO und LTU bzw. zwischen der Wortleitung WL und der Bitleitung BL hängt nun davon ab, ob die Magnetisierungsrichtung in den beiden Materialschichten WML und HML parallel oder antiparallel zueinander orientiert verläuft. Sind die Magnetisierungsrichtungen in den beiden Materialschichten WML und HML parallel zueinander orientiert, so liegt ein niedriger Widerstandswert des Widerstandes R vor, während bei einer antiparallelen Orientierung der Magnetisierung dieser Materialschichten ein hoher Widerstandswert des Widerstandes R zu verzeichnen ist. Da nun die hartmagnetische Materialschicht HML eine feste Magnetisierung hat, erfolgt das Schreiben der Speicherzelle durch Schalten der weichmagnetischen Materialschicht, indem an diese ein entsprechendes magnetisches Feld gelegt wird. Dieses magnetische Feld wird durch Überlagerung der beiden magnetischen Felder erzeugt, welche durch einen Strom I_{O} in dem oberen Leiter LTO und einen Strom I_{U} in dem unteren Leiter LTU gebildet sind. Mit anderen Worten, indem durch die Leiter LTO und LTU entsprechende Ströme I_{O} bzw. I_{U} in bestimmter Richtung geschickt werden, kann die Magnetisierungsrichtung in der weichmagnetischen Materialschicht WML umgeschaltet werden, so daß diese parallel oder antiparallel zu der Magnetisierungsrichtung der hartmagnetischen Materialschicht HML orientiert ist. Bei dem Beispiel von Fig. 3 werden antiparallel orientierte Magnetisierungen der beiden Materialschichten WML und HML angenommen, was durch entsprechende Pfeile angedeutet ist, so daß hier ein hoher Widerstandswert des Widerstandes R gegeben ist.

Bei dem Schalten der weichmagnetischen Materialschicht WML zwischen antiparallel und parallel orientierten Magnetisierungen in bezug auf die hartmagnetische Materialschicht HML und umgekehrt ist zu beachten, daß das weichmagnetische Material der Schicht WML Hystereseeigenschaft hat. Zum Auslösen des Schaltvorganges ist die Überlagerung der Magnetfelder, die von den Strömen I_{O} und I_{U} im oberen Leiter LTO bzw. im unteren Leiter LTU erzeugt sind, erforderlich. Für einen Schaltvorgang muß eine Umkehrung der ursprünglichen Stromrichtung des Stromes I_{O} bzw. des Stromes I_{U} vorgenommen werden.

Bei einem herkömmlichen DRAM sind die Wortleitungen jeweils mit den Gateanschlüssen von Schalttransistoren verbunden, so daß diese Wortleitungen auch mit den durch die Gateanschlüsse gebildeten Kapazitäten beaufschlagt sind. Dies bedeutet, daß eine Spannung zum schnellen Umladen der Kapazitäten für jede Wortleitung jeweils von einem Treiber bereitgestellt werden muß. Die Treiber von DRAMs bestehen nun aus n- und p-Kanal-Feldeffekttransistoren, damit niedrige und hohe Spannungen verlustfrei geschaltet werden können. Um aber für einen p-Kanal-Feldeffekttransistor die gleiche Treiberleistung wie für einen n-Kanal-Feldeffekttransistor zu erhalten, muß infolge der geringeren Ladungsträgermobilität in einem p-Kanal-Feldeffekttransistor für diesen eine etwa 2,5-fache Weite für den Kanal im Vergleich zu dem n-Kanal-Feldeffekttransistor angesetzt werden.

Ein herkömmlicher Treiber für die Wortleitungen eines DRAMs oder FeRAMs mit einem p-Kanal-Feldeffekttransistor P1 und einem n-Kanal-Feldeffekttransistor N0, die in Reihe zwischen einer Treiberspannung DRV und Masse liegen und mit ihren Gateanschlüssen an einem Ausleseanschluß RDOUTn angeschlossen sind, ist in Fig. 5 gezeigt. Am Verbindungspunkt zwischen diesen beiden Transistoren P1 und N0 liegt die Wortleitung WL. Die Kanalweite wp des p-Kanal-Feldeffekttransistors P1 beträgt das 2,5-fache der Kanalweite wn des n-Kanal-Feldeffekttransistors N0.

Bei einem MRAM wird zum Schreiben im Gegensatz zu einem DRAM ein hoher Strom von 2,5 bis 3 mA benötigt, während jedoch die Spannung über den einzelnen Speicherzellen zur Vermeidung von Durchbrüchen des Tunneloxidfilmes möglichst klein sein sollte. Wird beispielsweise eine Dicke d_{TL} der Tunneloxidschicht von 2 nm oder darunter angenommen, so sollte die Spannung am Tunneloxidfilm 0,5 V nicht überschreiten, damit eine Lebensdauer von 10 Jahren eingehalten werden kann.

Es ist nun Aufgabe der vorliegenden Erfindung, eine Strom-Treiberanordnung anzugeben, die bei niedrigem Flächenbedarf kleine Spannungen mit hohen Strömen zu liefern vermag.

Diese Aufgabe wird bei einer Strom-Treiberanordnung der eingangs genannten Art erfindungsgemäß dadurch gelöst, daß die Treiber jeweils aus einem n-Kanal-Feldeffekttransistor und einer zu diesem in Reihe liegenden Stromquelle bestehen.

Mit der erfindungsgemäßen Strom-Treiberanordnung können die erwünschten niedrigen Spannungen mit hohen Strömen, wie sie beim Schreiben und Lesen von MRAMs benötigt werden, mit den n-Kanal-Feldeffekttransistoren mit normalen Pegeln ohne Verluste auf Wortleitungen und Bitleitungen des MRAMs geschaltet werden. Diese n-Kanal-Feldeffekttransistoren benötigen bei gleicher Treiberleistung eine erheblich kleinere Fläche im Vergleich zu p-Kanal-Feldeffekttransistoren. Die dadurch erzielte Flächenreduzierung beträgt etwa einen Faktor 2,5, was auf die bereits erwähnte geringere Kanalweite zurückzuführen ist. Eine weitere Flächenreduzierung ist möglich, wenn zur Ansteuerung der n-Kanal-Feldeffekttransistoren angehobene bzw. geboostete Spannungen verwendet werden, welche die Treiberleistung erhöhen.

In einer Weiterbildung der Erfindung ist vorgesehen, daß an dem dem einen Ende gegenüberliegenden anderen Ende der Wortleitungen bzw. der Bitleitungen eine Reihenschaltung eines weiteren n-Kanal-Feldeffekttransistors mit einer Spannungsquelle zwischen diesem anderen Ende und Ground (Masse) liegt. Die Spannungsquelle kann dabei aus einem Widerstand, einer Transistordiode oder einer komplexen Schaltung bestehen.

Nachfolgend wird die Erfindung anhand der Zeichnungen näher erläutert. Es zeigen:
- Fig. 1: ein schematisches Schaltbild einer Strom-Treiberanordnung für einen MRAM nach einem Ausführungsbeispiel der Erfindung,
- Fig. 2: eine Speicherzelle eines MRAMs in Perspektive,
- Fig. 3: eine Seitendarstellung der Speicherzelle von Fig. 2,
- Fig. 4: ein schematisches Ersatzschaltbild für die Speicherzelle der Fig. 2 und 3 und
- Fig. 5: einen bestehenden Treiber für einen DRAM.

Die Fig. 2 bis 5 sind bereits eingangs erläutert worden.

In den Figuren werden einander entsprechende Bauteile jeweils mit den gleichen Bezugszeichen versehen.

Fig. 1 zeigt eine Strom-Treiberanordnung aus einem Treiber T1 für eine Bitleitung BL und einem Treiber T2 für eine Wortleitung WL. Der Treiber T1 besteht aus einer Stromquelle J3 und einem n-Kanal-Feldeffekttransistor N6 der Kanalweite wn, und der Treiber T2 weist in ähnlicher Weise eine Stromquelle J0 und einen n-Kanal-Feldeffekttransistor N0 mit der Kanalweite wn auf. Die Stromquelle J3 und der Feldeffekttransistor N6 liegen in Reihe zwischen einer Versorgungsspannungsquelle V_SupplyBL und der Bitleitung BL, und die Stromquelle J0 sowie der Feldeffekttransistor N0 liegen in ähnlicher Weise in Reihe zwischen einer Versorgungsspannungsquelle V_SupplyWL für die Wortleitung WL und der Wortleitung WL. Die Gateanschlüsse der beiden Transistoren N6 und N0 sind jeweils über ein Signal W ansteuerbar.

An der Kreuzung zwischen der Wortleitung WL und der Bitleitung BL liegt eine Speicherzelle Z, die einen Widerstand R (vgl. Fig. 4) bildet.

An dem dem Treiber T1 gegenüberliegenden Ende der Bitleitung BL liegt eine Reihenschaltung aus einem n-Kanal-Feldeffekttransistor N7 und einer Bezugsspannungsquelle V_RefBL (E0). Der negative Pol dieser Spannungsquelle E0 ist dabei mit Ground verbunden. Der Feldeffekttransistor N7 ist an seinem Gate durch das Signal W angesteuert und weist wie die Feldeffekttransistoren N0 und N6 eine Kanalweite wn auf.

Weiterhin ist an dem dem Treiber T2 gegenüberliegenden Ende der Wortleitung WL eine Reihenschaltung aus einem n-Kanal-Feldeffekttransistor N5 und einer Bezugsspannungsquelle V_RefWL (E1) vorgesehen. Der negative Pol dieser Spannungsquelle E1 ist mit Ground verbunden. Der Feldeffekttransistor N5 ist an seinem Gate mit dem Signal W angesteuert und weist eine Kanalweite wn auf.

Um die Stromrichtung in einer Leitung umschalten zu können, kann im allgemeinen Fall an beiden Enden der Wortleitung WL oder der Bitleitung BL der Stromtreiber angebracht werden. Hierzu wird schaltungstechnisch z. B. einfach die Stromquelle J0 durch eine Spannungsquelle (z. B. E1) und die Spannungsquelle E1 durch eine Stromquelle (z. B. J0) ergänzt. Gleiches kann auch auf die Bitleitung BL angewendet werden.

Beim Schreiben wird ein Schreibpfad in der Wortleitung WL und in der Bitleitung BL über das Signal W geöffnet. Der in der Wortleitung WL aus der Stromquelle J0 fließende Strom kann dann über die Feldeffekttransistoren N0 und N5 sowie die Bezugsspannungsquelle E1 nach Ground abfließen. Ebenso kann der Strom in der Bitleitung BL aus der Stromquelle J3 über die Feldeffekttransistoren N6 und N7 sowie die Bezugsspannungsquelle E0 nach Ground abfließen. In der Speicherzelle Z wird durch diese Ströme ein Magnetfeld erzeugt, das die Magnetisierung in der weichmagnetischen Schicht WML umschaltet.

Die Spannungsquellen E0 und E1 am Ende der Bitleitung BL bzw. am Ende der Wortleitung WL dienen zur Erzeugung von einstellbaren Bezugsspannungen. Diese Spannungsquellen können durch einen Widerstand, eine Transistordiode oder eine komplexe Schaltung realisiert werden und halten die Bitleitung BL bzw. die Wortleitung WL auf einem bestimmten Potential, wodurch Durchbrüche über den Speicherzellen Z verhindert werden.

Zur Ansteuerung der Feldeffekttransistoren N0 bzw. N6 können geboostete Spannungen verwendet werden, was eine Flächenreduzierung bei gleicher Treiberleistung erlaubt.

## Patentansprüche

1. Strom-Treiberanordnung für MRAM aus einem Speicherzellenfeld mit einer Vielzahl von Speicherzellen (Z) an Kreuzungsstellen von Wortleitungen (WL) mit Bitleitungen (BL) und aus den Wortleitungen (WL) und den Bitleitungen (BL) zugeordneten Treibern (T1, T2), die jeweils an einem Ende der Wortleitungen (WL) bzw. Bitleitungen (BL) vorgesehen sind,
**dadurch gekennzeichnet, daß**
- die Treiber (T1, T2) jeweils aus einem n-Kanal-Feldeffekttransistor (N0, N6) und einer zu diesen in Reihe liegenden Stromquelle (J0, J3) bestehen, und
- an dem dem einen Ende gegenüberliegenden anderen Ende der Wortleitungen (WL) und der Bitleitungen (BL) eine Reihenschaltung eines weiteren n-Kanal-Feldeffekttransistors (N5, N7) mit einer Spannungsquelle (E1, E0) zwischen diesem anderen Ende und Ground liegt.

2. Strom-Treiberanordnung nach Anspruch 1,
**dadurch gekennzeichnet, daß** die Spannungsquelle (E1, E0) aus einem Widerstand, einer Transistordiode oder einer komplexen Schaltung besteht.

3. Strom-Treiberanordnung nach Anspruch 1 oder 2,
**dadurch gekennzeichnet, daß** die n-Kanal-Feldeffekttransistoren (N6, N0) der Treiber (T1, T2) durch geboostete Spannungen angesteuert werden können.
